## Europäisches Patentamt
## European Patent Office
## Office européen des brevets

(19)

(11) Numéro de publication: **0 026 372**
**B1**

# FASCICULE DE BREVET EUROPEEN

(45) Date de publication du fascicule du brevet: **07.01.87**

(51) Int. Cl.⁴: **H 04 L 27/06, H 03 D 1/24**

(21) Numéro de dépôt: **80105454.5**

(22) Date de dépôt: **12.09.80**

(54) **Circuit d'asservissement de la phase d'un oscillateur local pour récepteur de signaux de données transmis par une modulation d'amplitude en bande latérale unique.**

(30) Priorité: **19.09.79 FR 7923306**

(43) Date de publication de la demande:
**08.04.81 Bulletin 81/14**

(45) Mention de la délivrance du brevet:
**07.01.87 Bulletin 87/02**

(84) Etats contractants désignés:
**BE DE FR GB IT LU NL**

(56) Documents cités:
**DE-B-2 444 429**
**FR-A-2 305 074**
**FR-A-2 419 614**

**IEEE TRANSACTIONS ON COMMUNICATIONS, vol. COM-24, no. 1, janvier 1976, pages 146-148 New York, U.S.A. E.F. LAWRENCE: "On the use of polarity coincidence correlation techniques for differential phaseshift-keyed demodulation"**

(73) Titulaire: **ALCATEL**
**12, rue de la Baume**
**F-75008 Paris (FR)**

(72) Inventeur: **Lemoussu, Michel**
**15, Allée des Erables**
**F-91240 Saint Michel Sur Orge (FR)**
Inventeur: **Cardot, Claude**
**Chateau de Courcelle**
**F-91190 Gif Sur Yvette (FR)**

(74) Mandataire: **Weinmiller, Jürgen et al**
**Lennéstrasse 9**
**D-8133 Feldafing (DE)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

EP 0 026 372 B1

# 0 026 372

**Description**

La présente invention concerne les transmissions numériques et plus particulièrement la récupération de la porteuse non nécessairement émise d'un signal de données transmis par une modulation d'amplitude en bande latérale unique.

Dans les premiers systèmes de transmission de données employant une modulation d'amplitude, la récupération de la porteuse s'effectuait, à la réception, à partir d'un reste de porteuse laissé à cette fin dans le signal émis ou à partir de fréquences pilotes particulières ajoutées au signal émis. Mais cela provoquait un encombrement du spectre des fréquences d'émission et une diminution du rendement de la transmission. On a également proposé, notamment dans le brevet français 2 305 074, de récupérer la porteuse à partir du rythme de bits celui-ci étant, dans certains systèmes de transmission, présent dans le signal résultant du redressement du signal transmis et par conséquence récupérable à l'aide d'un oscillateur pourvu d'une simple boucle à verrouillage de phase. Mais cela nécessite un signal numérique codé sous une forme pseudo-ternaire et surtout des relations étroites en fréquence et en phase entre le rythme de bits et la fréquence de la porteuse qu'il est difficile de conserver lorsque la transmission emprunte des liaisons à courants porteurs. Aussi a t'on proposé, par la suite, de récupérer la porteuse à partir de certaines caractéristiques du signal de données reçu et démodulé, sans prendre en compte des fréquences pilotes ni un résidu de porteuse. C'est ainsi que, dans le cas des transmissions numériques synchrones utilisant une modulation d'amplitude en bande latérale unique, on connaît des circuits de récupération de porteuse utilisant un oscillateur commandé par un asservissement tendant à annuler la valeur moyenne du signal reçu et démodulé entre deux transitions consécutives et de même sens, ou tendant à rendre maximale une composante, au double de la fréquence des symboles du signal numérique synchrone, composante qui est tirée de l'élévation au carré du signal reçu et démodulé, ou encore tendant à rendre équidistants en moyenne des passages par zéro d'ordre pair et d'ordre impair du signal reçu et démodulé. Des circuits de récupération de porteuse de ce dernier type sont connus par la demanderesse. Ils sont décrits dans la demande de brevet français publiée le 5 octobre 1979 sous le n° 2 419 614 par de demanderesse. Ils comportent essentiellement un oscillateur à fréquence variable (VCO) commandé en tension par un autocorrélateur à coïncidence de signes qui fonctionne à partir de deux versions du signal reçu et démodulé retardées l'une par rapport à l'autre d'un multiple entier d'un intervalle de temps unitaire du signal numérique synchrone considéré. Ces derniers circuits ont l'avantage d'être principalement constitués d'éléments fonctionnant par tout ou rien pouvant être réalisés de manière économique par les technologies habituellement utilisées pour la réalisation des circuits numériques.

La présente invention a pour but la réalisation d'un circuit de récupération de porteuse du genre précédent également, ne nécessitant pas, dans le signal transmis, la présence d'un résidu de porteuse ni de fréquences pilotes particulières, également réalisable de manière simple avec encore plus d'éléments fonctionnant par tout ou rien.

Elle a pour objet un circuit d'asservissement de la phase d'un oscillateur local muni d'un moyen de réglage de fréquence et engendrant une porteuse locale pour démoduler un signal de données transmis par une modulation d'amplitude à bande latérale unique. Ce circuit d'asservissement comporte au moins un multiplicateur de signes effectuant le produit du signe de la porteuse locale de démodulation affectée d'un écart de phase de $\pi/4$, par le signe du signal de données à démoduler, suivi d'un autocorrélateur à coïncidence de signes commandant le moyen de réglage de fréquence et effectuant la corrélation entre deux versions du signal délivré par le multiplicateur de signes, lesdites versions étant retardées l'une par rapport à l'autre d'un multiple impair d'un quart de la période de la porteuse ayant servi à l'émission pour réaliser la modulation d'amplitude.

D'autres caractéristiques et avantages de l'invention ressortiront des revendications jointes et de la description ci-après de deux modes de réalisation donnés à titre d'exemple. Cette description sera fraite en regard du dessin dans lequel:

— la figure 1 est le schéma d'un démodulateur mettant en oeuvre un oscillateur local muni d'un circuit d'asservissement de phase selon l'invention,
— la figure 2 est un diagramme de courbes aidant à la compréhension du démodulateur de la figure 1
— et la figure 3 est le schéma d'une variante du démodulateur représenté à la figure 1.

Dans la suite de la description on va se limiter à un système de transmission de données utilisant une modulation d'amplitude à bande latérale unique avec conservation de la bande latérale inférieure, mais il est évident que l'invention s'applique également au cas où c'est la bande latérale supérieure qui est conservée.

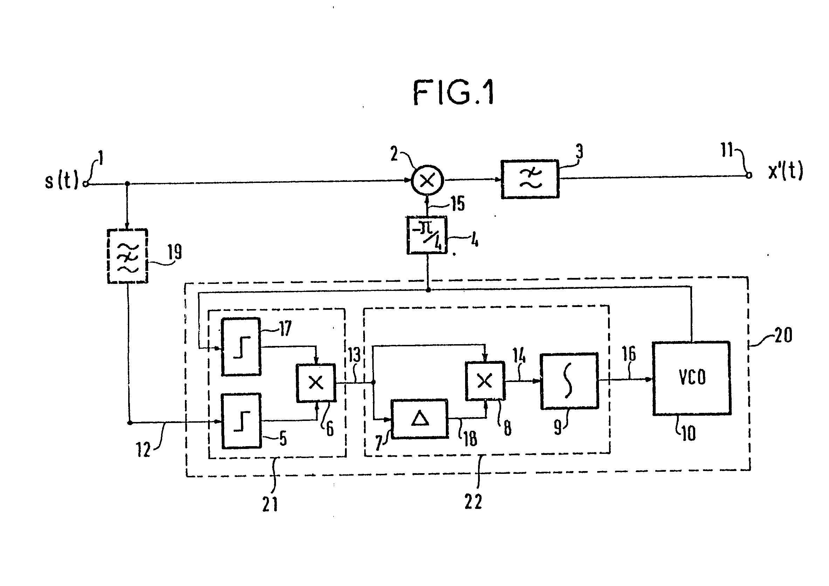

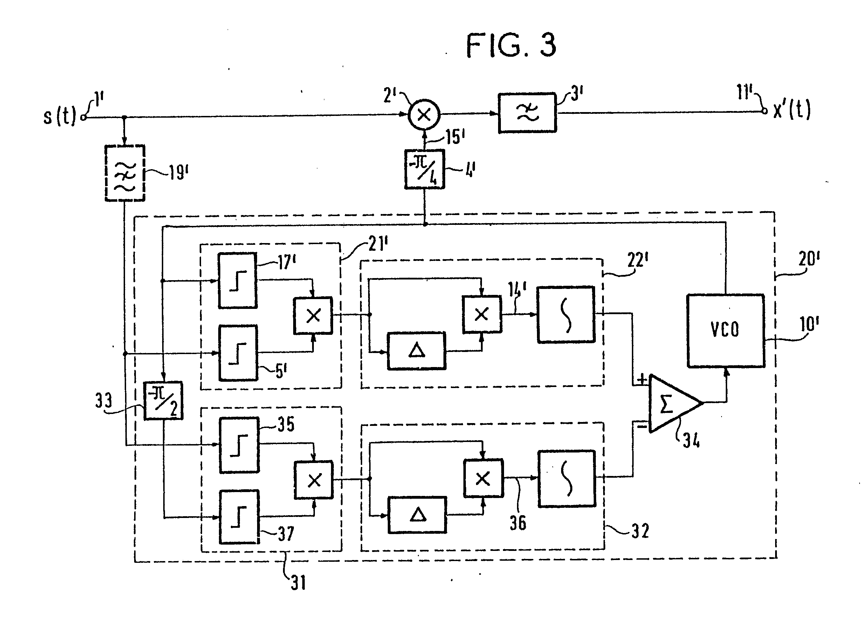

Les démodulateurs représentés aux figures 1 et 3 comportent chacun un modulateur linéaire 2, 2' et un filtre passe-bas 3, 3' connectés en série avec leur entrée 1, 1', et leur sortie 11, 11', ainsi qu'un circuit de récupération de porteuse 20, 20' avec un oscillateur à fréquence variable commandé en tension 10, 10' muni d'un circuit d'asservissement de phase selon l'invention.

Le signal s(t) qui est appliqué à l'entrée 1, 1' des démodulateurs et qui résulte d'une modulation d'amplitude à bande latérale unique avec conservation de la bande latérale inférieure a pour expression:

**0 026 372**

$$s(t)=x(t) \cos wt+\hat{x}(t) \sin wt \tag{1}$$

x(t) étant le signal modulant, $\hat{x}(t)$ le transformé de Hilbert du signal x(t) et w la pulsation de la porteuse utilisée à l'émission pour la modulation. Pour la justification de cette expression on peut se reporter par exemple aux pages 170 à 174 de l'ouvrage de Lucky, Salz et Weldon intitulé "Principles of Data Communication" et publié en 1968 par McGraw-Hill.

Le signal modulant x(t) résulte de données binaires $a_i$ synchrones, codées et mises en forme; il peut s'exprimer par:

$$x(t)= \sum_{i=-\infty}^{+\infty} a_i \, g(t-i \, T)$$

g(t) étant l'impulsion élémentaire transmise et T la durée de l'intervalle élémentaire (temps Baud). On peut se reporter pour davantage de détails au chapitre 4 de l'ouvrage précité.

En supposant que la porteuse locale appliquée sur l'entrée 15 du modulateur linéaire 2 et fournie par le circuit de récupération de porteuse 20, 20' ait même fréquence que la porteuse utilisée à l'émission pour réaliser la modulation mais soit en retard de phase d'un angle θ par rapport à la phase de la porteuse qui assurerait la meilleure démodulation on retrouve alors en sortie 11, 11' du filtre passe-bas 3, 3' (qui ne conserve que le battement inférieur engendré par la modulateur 2, 2'), un signal x'(t) de la forme

$$x'(t)=x(t) \cos\theta+\hat{x}(t) \sin \, \theta$$

qui n'est égal au signal modulant x(t) ou à son opposé que si l'angle θ est nul à kπ près. C'est pourquoi il est nécessaire de régler la phase de la porteuse utilisée à la réception pour la démodulation; cette fonction est dévolue aux circuits de récupération de porteuse 20 et 20' des démodulateurs représentés aux figures 1 et 3.

Le circuit de récupération de porteuse 20 du démodulateur représenté à la figure 1 comporte un oscillateur 10 qui est muni d'un circuit d'asservissement de phase. Cet oscillateur 10 engendre une onde dont la fréquence est celle de la porteuse locale et présente une avance de phase de π/4 par rapport à cette dernière. L'oscillateur 10 est un oscillateur à fréquence variable en fonction d'une tension appliquée sur une borne de commande 16. Sa sortie est connectée à l'entrée 15 du modulateur linéaire 2 par l'intermédiaire d'un déphaseur fixe 4 qui rattrape l'avance de phase. Le circuit d'asservissement de phase comporte un multiplicateur de signes 21 effectuant le produit du signe du signal de sortie de l'oscillateur 10 par le signe du signal de données s(t) reçu en entrée 1 du démodulateur, et un autocorrélateur a6 coïncidence de signes 22 relié à la borne de commande de l'oscillateur 10 et effectuant la corrélation entre deux versions du signal de sortie du multiplicateur de signes 21, lesdites versions étant retardées l'une par rapport à l'autre d'un délai Δ égal à un multiple impair du quart de la période de la porteuse utilisée à l'émission pour la modulation:

$$\Delta=(2k+1)\frac{\pi}{2w}$$

k étant un entier.

Le multiplicateur de signes 21 est formé d'un premier limiteur absolu 5 dont l'entrée est connectée à celle du démodulateur et qui délivre un signal binaire:

$$\text{sgn}[s(t)]$$

égal à +1 si s(t) est positif et à −1 dans le cas contraire, d'un deuxième limiteur absolu 17 dont l'entrée est connectée à la sortie de l'oscillateur 10 et qui agit de même sur le signal de cet oscillateur, et d'un premier multiplicateur binaire 6 à deux entrées, l'une connectée à la sortie du premier limiteur absolu 5, l'autre à celle du deuxième limiteur absolu 17, effectuant le produit des deux grandeurs égales à ±1 qu'il reçoi, produit qui constitue le signal de sortie du multiplicateur de signes 21.

L'autocorrélateur à coïncidence de signes 22 comporte un circuit à retard 7 qui introduit un délai égal à Δ et qui est connecté, en entrée, à la sortie du premier multiplicateur binaire 6, un deuxième multiplicateur binaire 8 à deux entrées connectées à la sortie du premier multiplicateur binaire 6, l'une directement, l'autre par l'intermédiaire du circuit à retard 7, et un intégrateur 9 disposé à la suite du deuxième multiplicateur binaire 8. En réponse aux signaux binaires ±1 qu'il reçoit sur ses entrées, le deuxième multiplicateur délivre un signal binaire égal à ±1 appliqué à l'intégrateur 9 qui en effectue la moyenne sur une durée grande par rapport à T et qui délivre la tension de commande de l'oscillateur 10.

Le circuit de récupération de porteuse 20 peut subir différentes modifications qui n'en altérent pas le fonctionnement:

3

— Dans le cas où l'oscillateur 10 délivre un signal rectangulaire à la fréquence de la porteuse et non un signal sinusoïdal, de deuxième limiteur absolu 17 est sans objet et doit être supprimé. Dans ce cas, le déphaseur 4 doit être remplacé par un circuit de retard introduisant un retard de

$$\frac{\pi}{4w}.$$

— Les signaux circulant dans les organes 6, 7 et 8 ont été supposés ci-dessus avoir pour valeurs possibles: +1 et −1. Mais ils peuvent aussi bien avoir pour valeurs: +1 et 0. dans ce cas les multiplicateurs binaires 6 et 8 sont des additionneurs modulo 2 et les limiteurs absolus 5 et 17 sont agencés de telle sorte qu'ils délivrent les signaux +1 et 0 selon le signe de leur signal d'entrée. En effet il est connu que la table d'addition modulo 2 et la table de multiplication des nombres +1 et −1 sont isomorphes, de telle sorte que les signaux de commande apparaissant en sortie 16 du circuit d'asservissement de phase sont fonctions linéaires l'un de l'autre.

— Le fonctionnement du circuit d'asservissement de phase ne suppose nullement qu'un résidu de porteuse accompagne le signal émis. Au contraire, si un tel résidu est émis en ligne, il risque de la perturber et l'on peut, le cas échéant, éliminer ledit résidu de porteuse au moyen d'un filtre coupe-bande 19 intercalé entre l'entrée 1 du démodulateur et celle du limiteur absolu 5. Ce filtre coupe-bande 19 supprime alors dans le signal reçu les pulsations, qui sont voisines de celles de la porteuse.

Le circuit d'asservissement de phase du démodulateur qui vient d'être décrit fonctionne sous les deux conditions suivantes:

1) la suite des symboles binaires $a_i$, porteurs de l'information à transmettre, est aléatoire (ceci est toujours réalisé dans la pratique, en raison de la présence de brouilleurs dans les émetteurs d'information),

2) l'impulsion élémentaire g(t) utilisée pour la transmission est de moyenne temporelle nulle:

$$\int_{-\infty}^{+\infty} g(t).dt=0$$

(cette condition est toujours réalisée en transmission sur câbles, car si la moyenne temporelle de g(t) n'était pas nulle, le câble recevrait une charge électrique croissante avec le temps). C'est le cas, en particulier, si l'on utilise un codage et une mise en forme de type réponse partielle de classe 4.

Une caractéristique essentielle du circuit d'asservissement de phase est de ne fonctionner que pendant une partie du temps (périodes d'activité) et de ne modifier en rien la fréquence de l'oscillateur commandé 10 pendant le reste du temps (périodes de neutralité).

Dans l'exemple non limitatif où l'impulsion élémentaire utilisée est celle de la réponse partielle classe 4, les périodes d'activité représentent 1/8 du temps total de fonctionnement du dispositif.

Les simulations sur ordinateur et l'expérience montrent qu'une période d'activité de cet ordre de grandeur est suffisante pour assurer un verrouillage stable et efficace de la phase de l'oscillateur local.

Si nous nous reportons à la figure 1, nous voyons que le signal sortant du limiteur absolu 5 a pour expression:

$$sgn[s(t)].$$

Ce signal ne dépend que de la fréquence instantanée du signal analytique associé à x(t).

Si nous appelons cos (wt+Ø) le signal issu de l'oscillateur local, Ø étant l'erreur de phase instantanée de cet oscillateur, le signal issu du limiteur absolu 17 sera:

$$sgn[cos(wt+Ø)]$$

et le signal produit au point 13 par le premier multiplicateur binaire sera:

$$S_{13}=sgn[s(t) \cdot cos(wt+Ø)]$$

Si la fréquence angulaire instantanée du signal analytique associé à x(t) est, en un instant donné, différente de w, le signal apparaissant en 13 sera à moyenne temporelle nulle.

Par exemple,

$$si: s(t)=cos(w't+Ø')$$

avec w'≠w

alors:

$$S_{13}=sgn[s(t) \cdot cos \ (wt+Ø)]$$

$$=sgn \ [cos \ (wt+Ø) \cdot cos(w' \ t+Ø)]$$

$$=sgn \ [cos((w+w')t+(Ø+Ø'))+cos((w-w')t+(Ø-Ø'))]$$

4

**0 026 372**

L'expression entre crochets étant la somme de deux fonctions sinusoïdales de fréquences différentes, celles-ci sont indépendantes au sens de Steinhaus et cette expression entre crochets est aussi souvent positive que négative, de sortie que la moyenne du signe tend vers zéro sur un intervalle suffisant. Tant que cette condition est remplie, l'asservissement est dans une période de neutralité. Les fluctuations à moyenne nulle des signaux $S_{13}$ délivrés par le premier multiplicateur 6 et $S_{14}$ délivrés par le deuxième multiplicateur 8 sont éliminées par l'intégrateur 9 et la fréquence de l'oscillateur 10 demeure constante.

Par contre, si la fréquence angulaire du signal analytique associé à x(t) est égale à w, le signal apparaissant en 13 a une moyenne temporelle non nulle:

$$\text{Si } s(t)=A \cdot \sin wt, \text{ on aura:}$$

$$S_{13}=\text{sgn } [s(t) \cdot \cos (wt+\emptyset)]$$

$$=\text{sgn } [A \cdot \sin wt \cdot \cos(wt+\emptyset)]$$

$$=\text{sgn } [A] \cdot \text{sgn } [\sin(2 wt+\emptyset)-\sin \emptyset]$$

expression dont la moyenne temporelle tend vers:

$$\text{Moy } (S_{13})=\text{sgn } [A] \cdot \frac{-2\emptyset}{\pi}$$

sur un temps d'intégration suffisant.

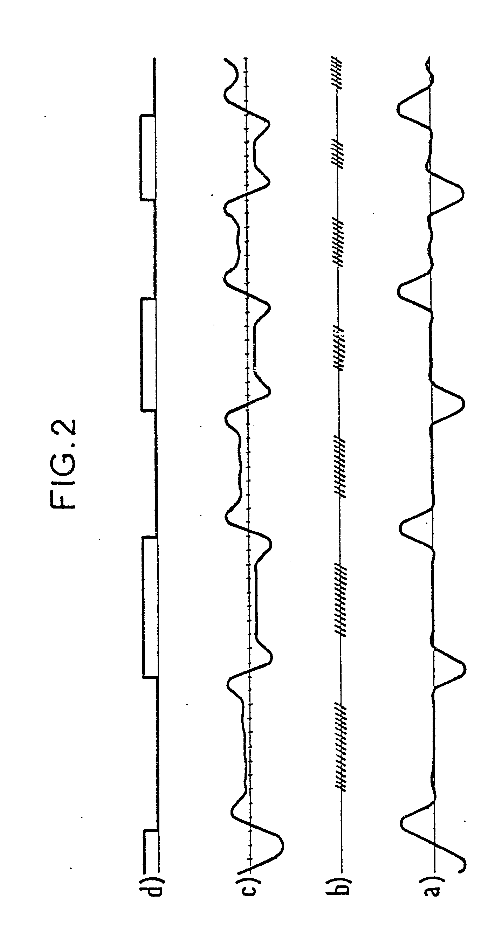

L'asservissement est alors en période d'activité. Pour qu'une telle période d'activité existe, la formule (1) montre que ceci suppose une durée où le signal x(t) issu du codage et de la mise en forme est négligeable devant son transformé de Hilbert x̂(t) et où ce dernier ne s'annule pas. De telles durées sont habituelles dans une transmission de données utilisant une impulsion élémentaire g(t) à valeur moyenne nulle. Le diagramme des fourbes de la figure 2 illustre cette propriété pour une transmission de données utilisant un codage et une mise en forme du type réponse partielle classe 4. La courbe d montre une suite de symboles $a_i$ émis, comportant des groupes consécutifs de plus de quatre symboles égaux à 0 ou à 1 (cette suite n'est pas aléatoire mais conçue pour les besoins de la démonstration). La courbe a montre le signal x(t) correspondant obtenu après codage et mise en forme. La courbe c montre le signal x̂(t) transformé de Hilbert du signal x(t).

On voit, d'après cette figure 2 que pour toute suite de k symboles consécutifs de même nature, k étant supérieur ou égal à 4, il existe une durée (k–3) T pendant laquelle x(t) demeure négligeable et où son transformé de Hilbert x̂(t) ne change pas de signe. Ces durées, qui sont repérées par les hachures b, sont les périodes d'activité de l'asservissement de phase. Pendant ces périodes la fréquence instantanée du signal analytique correspondant à x(t) est voisine de zéro.

Si la suite des $a_i$ est parfaitement aléatoire, les périodes d'activité de l'asservissement représentent 1/8 du temps.

En effet, dans une suite aléatoire, un élément pris au hasard a la probabilité:

$$\frac{k}{2^{k+1}}$$

d'appartenir à une séquence de k symboles identiques.

$$\left(\text{On a évidemment: } \sum_{1}^{\infty} \frac{k}{2^{k+1}}=1\right)$$

Sachant qu'une séquence de k symboles identiques produit une période d'activité égale à (k–3)T, il en résulte que la proportion du temps pendant laquelle l'asservissement se trouve en période d'activité est donnée par:

$$\sum_{k=4}^{\infty} \frac{k-3}{k} \cdot \frac{k}{2^{k+1}} = \sum_{k=4}^{\infty} \frac{k-3}{2^{k+1}}=\frac{1}{8}$$

On peut également déduire de la figure 2, et confirmer par le calcul, qu'il n'existe pas de durées significatives pendant lesquelles x̂(t) demeurerait négligeable. Ceci résulte de la forme de la transformée de Hilbert d'une impulsion à moyenne nulle.

Il peut sembler surprenant qu'il existe des durées significatives pendant lesquelles le signal appliqué

5

au premier multiplicateur binaire 6 conserve une fréquence angulaire instantanée peu différente de w alors que cette fréquence n'existe pas dans le spectre du signal incident s(t), et que le filtre coupe-bande (facultatif) 19 a même pour rôle de la supprimer si elle existe.

L'explication de ce fait est que le signal au point 1 ou au point 12 est pendant les périodes d'activité de la forme A(t) · Sin wt, où A(t) est une quantité qui varie (sans changer de signe) et qui représente l'amplitude instantanée du signal analytique pendant ces périodes. Le spectre du produit: A(t) · sin wt ne renferme pas la fréquence w; par contre, à la sortie de l'organe non linéaire 5, la fréquence angulaire du signal étant w pendant les périodes d'activité, les passages par zéro sont séparés par π/w.

Pour expliquer le rôle de l'autocorrélateur à coïncidence de signes 22 pendant les périodes d'activité de l'asservissement de phase il suffit de calculer l'expression de son signal de sortie $S_{16}$.

L'autocorrélateur à coïncidence de signes 22 reçoit du multiplicateur de signes 21 un signal $S_{13}$ de la forme:

$$S_{13}=\text{sgn } [A \cdot \sin \text{ wt. cos (wt}+\emptyset)]$$

Le circuit à retard 7 ayant une constante de temps:

$$\Delta=\pi/2w$$

délivre un signal $S_{18}$ de la forme

$$S_{18}=\text{sgn } [A \sin(wt-\pi/2). \cos(wt+\emptyset-\pi/2)]$$

$$=\text{sgn } [-A \cos \text{ wt. } \sin(wt+\emptyset)]$$

Le signal $S_{14}$ apparaissant en sortie du deuxième multiplicateur binaire 8 est le produit des signaux $S_{13}$ et $S_{18}$. Il est de la forme:

$$S_{14}=\text{sgn } [-A^2 \sin \text{ 2wt. } \sin 2(wt+\emptyset)]$$

$$=\text{sgn } [\cos(4wt+2\emptyset)-\cos 2\emptyset]$$

L'intégrateur 9 en tire la valeur moyenne:

$$\text{Moy}(S_{14})=\frac{4\emptyset-\pi}{\pi}$$

Cette formule montre:

— que le signal de sortie de l'intégrateur 9 ne dépend que de Ø, ce qui est le but recherché,
— que ce signal sera nul en moyenne, si Ø=π/4.

Il en résulte que la boucle d'asservissement de phase représentée par la figure 1 stablisera la porteuse à une phase telle qu Ø=π/4. Il est donc nécessaire, pour que le signal appliqué au modulateur linéaire 2 produise une démodulation correcte, de disposer entre la sortie de l'oscillateur local, 10, et l'entrée 15 du modulateur linéaire 2 un déphaseur fixe, 4, produisant à la fréquence de la porteuse un déphasage fixe, dont la valeur théorique est: −π/4. Il va de soi que, compte tenu des imperfections d'un système réel, la valeur de ce déphasage sera ajustée expérimentalement, pour obtenir l'ouverture maximale du diagramme de l'oeil.

Le fonctionnement du circuit conforme à l'invention demeure identique, et satisfait aux mêmes équations, si le retard apporté par la ligne à retard 7 est un multiple impair quelconque de t=π/2w.

Dans le schéma de la figure 1 on a omis les amplificateurs à gain fixe, éventuellement nécessaires en divers points pour assurer un fonctionnement correct des organes représentés. La définition de ces amplificateurs relève du domaine courant de l'homme de l'art.

La figure 3 représente une variante du démodulateur qui vient d'être décrit relativement à la figure 1. Dans cette variante le circuit de récupération de porteuse est muni d'un circuit d'asservissement de phase dédoublé fonctionnant à l'aide de deux versions en quadrature de la porteuse locale. On a repis dans cette figure, pour les éléments invariants par rapport à la figure 1, les mêmes indexations affectées d'un prime.

On retrouve dans ce démodulateur, comme dans le précédent, un modulateur linéaire 2' connecté en série avec un filtre passebas 3' entre l'entrée 1' et la sortie 11', ainsi qu'un circuit de récupération de porteuse 20' avec un oscillateur à fréquence variable commandé en tension 10' connecté à une entrée 15' du modulateur linéaire 2' par l'intermédiaire d'un déphaseur fixe 4' et muni d'un circuit d'asservissement de phase. Ce circuit d'asservissement de phase est doublé par rapport au précédent. Il comporte:

— un premier multiplicateur de signes 21' effectuant le produit du signe du signale de sortie de l'oscillateur 10' par le signe du signal de données s(t) reçu en entrée 1' du démodulateur,

— un deuxième multiplicateur de signes 31 effectuant le produit du signe du signal de sortie de l'oscillateur 10' affecté d'un retard de phase π/2 par un déphaseur 33, par le signe du signal de données s(t) reçu en entrée 1' du démodulateur,

— un premier autocorrélateur à coïncidence de signes 22' effectuant la corrélation entre deux versions du signal de sortie du premier multiplicateur de signes 21' retardées l'une par rapport à l'autre d'un délai Δ égal à un multiple impair du quart de la période de la porteuse utilisée à l'émission pour la modulation,

$$\Delta = (2k+1)\frac{\pi}{2w} \quad k \text{ entier}$$

— un deuxième autocorrélateur à coïncidence de signes 32 effectuant la corrélation entre deux versions du signal de sortie du deuxième multiplicateur de signes 31, retardées l'une par rapport à l'autre du délai Δ

— et un amplificateur différentiel 34 présentant une entrée non inverseuse connectée à la sortie du premier autocorrélateur à coïncidence de signes 22', une entrée inverseuse connectée à la sortie du deuxième autocorrélateur à coïncidence de signes 32 et une sortie connectée à une borne de commande de l'oscillateur 10'.

Chaque multiplicateur de signes est constitué d'un multiplicateur binaire à deux entrées comportant sur chacune de ses deux entrées un limiteur absolu.

Chaque autocorrélateur à coïncidence de signes est constitué d'un multiplicateur binaire à deux entrées comportant sur l'une d'elles un circuit à retard de délai Δ et sur sa sortie un intégrateur dont la constante de temps est grande par rapport à l'intervalle de temps élémentaire T.

Le circuit de récupération de porteuse 20' ne comporte pas, lorsqu'il est réalisé en pratique, tous les éléments représentés à la figure 3 car certaines de ses parties ont été dédoublées dans le but de faire apparaître sa parenté avec le circuit de récupération de porteuse du démodulateur décrit précédemment relativement à la figure 1. C'est le cas notamment des limiteurs absolus 5' et 35. C'est également le cas des limiteurs absolus 17' et 37 qui en fait ne sont qu'un seul et même élément placé devant le circuit 33 qui dans ce cas est un circuit de retard introduisant un retard de π/2 w.

Les éléments 2', 3', 4' et 19' ont les mêmes rôles que leurs correspondants 2, 3, 4 et 19 dans le modulateur de la figure 1. Leur fonctionnement ne sera pas redécrit.

Le fonctionnement du premier multiplicateur de signes 21' et du premier autocorrélateur à coïncidence de signes 22' est le même que celui du multiplicateur de signes 21 et de l'autocorrélateur à coïncidence de signes 22 du modulateur de la figure 1 de sorte que, si on reprend les hypothèses de fonctionnement du démodulateur de la figure 1, le signal $S_{14'}$ à la sortie du multiplicateur du premier autocorrélateur à coïncidence de signes 22' a pour expression, pendant les périodes d'activité de l'asservissement de phase:

$$S_{14'} = S_{14} = \text{sgn}[\cos(4wt+2\emptyset) - \cos 2\emptyset]$$

Le deuxième multiplicateur de signes 31 et le deuxième autocorrélateur à coïncidence de signes 32 ont un fonctionnement analogue. Compte tenu qu'ils reçoivent le signal de l'oscillateur avec un retard de phase de π/2, le signal $S_{36}$ à la sortie du multiplicateur du deuxième autocorrélateur à coïncidence de signes 32 a pour expression, pendant les périodes d'activité de l'asservissement de phase:

$$S_{36} = \text{sgn}[\cos 2\emptyset - \cos(4wt+2\emptyset)] = -S_{14'} = -S_{14}$$

Les deux autocorrélateurs à coïncidence de signes 22' et 32 délivrent donc deux signaux de correction égaux et de signes opposés. Leur soustraction dans l'amplificateur différentiel 34 permet alors de doubler la sensibilité du circuit d'asservissement de phase.

La structure du circuit d'asservissement de phase 20' présente également, par rapport à celle du circuit d'asservissement de phase 20 du démodulateur de la figure 1, l'avantage de diminuer considérablement l'influence des dérives pouvant apparaître dans les chaînes d'amplification à courant continu, notamment dans les intégrateurs du fait que les dérives des deux chaînes agissent en sens inverse sur le signal de correction final.

En variant, il est possible de réaliser chacun des multiplicateurs de signes 21 de la figure 1, 21' et 31 de la figure 3 à l'aide d'un multiplicateur analogique suivi d'un limiteur absolu, le multiplicateur analogique recevant, sur une première absolu, le multiplicateur analogique recevant, sur une première entrée, le signal s(t) et sur une seconde entrée l'onde porteuse issue de l'oscillateur à fréquence variable 10, 10' éventuellement déphasée par un réseau déphaseur 33.

**Revendications**

1. Circuit d'asservissement de la phase d'un oscillateur local (10) muni de moyen d'un réglage de fréquence et engendrant une porteuse locale pour démoduler un signal de données transmis par une modulation d'amplitude en bande latérale unique qui comporte:

— un multiplicateur de signes (21) effectuant le produit entre d'une part le signe du signal de sortie de l'oscillateur local déphasé de π/4 par rapport à la porteuse locale (sur 15), et d'autre part le signe du signal de données reçu non démodulé (s(t)) et,
— un autocorrélateur à coïncidence de signes (22) commandant ledit moyen de réglage en fréquence et effectuant la corrélation entre deux versions du signal délivré par le multiplicateur de signes, retardées (dans 7) l'une par rapport à l'autre d'un multiple impair d'un quart de période de porteuse.

2. Circuit d'asservissement selon la revendication 1, caractérisé en ce que le multiplicateur de signes (21) reçoit le signal à démoduler par l'intermédiaire d'un filtre coupe-bande (19) supprimant un éventuel résidu de la porteuse ayant servi à l'émission pour réaliser la modulation d'amplitude.

3. Circuit d'asservissement selon la revendication 1, caractérisé en ce que le multiplicateur de signes (21) comporte:

— un premier limiteur absolu (5) recevant en entrée le signal de données à démoduler et délivrant en sortie un signal binaire correspondant au signe du signal de données à démoduler,
— un deuxième limiteur absolu (17) recevant en entrée la porteuse locale affectée d'un écart de phase de π/4 et délivrant en sortie un signal binaire correspondant au signe de la porteuse locale affectée d'un écart de phase de π/4
— et d'un premier multiplicateur binaire (6) à deux entrées l'une connectée à la sortie du premier limiteur absolu (5) l'autre à celle du deuxième limiteur absolu (17).

4. Circuit d'asservissement selon la revendication 1, caractérisé en ce que l'autocorrélateur à coïncidence de signes (22) comporte:

— un circuit à retard (7) dont l'entrée est connectée à la sortie du multiplicateur de signes (21) et qui introduit un délai égal à un multiple impair d'un quart de période de la porteuse ayant servi à l'émission pour la réalisation de la modulation d'amplitude,
— un deuxième multiplicateur binaire (8) à deux entrées connectées à la sortie du multiplicateur de signes (21), l'une directement, l'autre par l'intermédiaire du circuit à retard (7)
— et un intégrateur (9) connecté à la sortie du deuxième multiplicateur binaire (8).

5. Circuit d'asservissement selon la revendication 1, caractérisé en ce qu'il comporte:

— un premier multiplicateur de signes (21') effectuant le produit du signe de la porteuse locale affectée d'une avance de phase dont la valeur théorique est π/4 par le signe du signal de données à démoduler,
— un deuxième multiplicateur de signes (31) effectuant le produit du signe de la porteuse locale affectée d'un retard de phase dont la valeur théorique est de π/4 par le signe du signal de données à démoduler,
— un premier autocorrélateur à coïncidence de signes (22') effectuant la corrélation entre deux versions du signal délivré par le premier multiplicateur de signes (21'), lesdites versions étant retardées l'une par rapport à l'autre d'un multiple impair d'un quart de période de la porteuse ayant servi à l'émission pour réaliser la modulation d'amplitude,
— un deuxième autocorrélateur à coïncidence de signes (32) effectuant la corrélation entre deux versions du signal délivré par le deuxième multiplicateur de signes (31), lesdites versions étant retardées l'une par rapport à l'autre d'un multiple impair d'un quart de période de la porteuse ayant servi à l'émission pour réaliser la modulation d'amplitude
— et un amplificateur différentiel (34) ayant une première entrée connectée à la sortie du premier autocorrélateur à coïncidence de signes (22') et une deuxième entrée connectée à la sortie du deuxième autocorrélateur à coïncidence de signes (32) et délivrant le signal de sortie du circuit d'asservissement.

**Patentansprüche**

1. Phasenregelkreis für einen örtlichen Oszillator (10), der ein Mittel zur Frequenzregelung aufweist und einen örtlichen Träger zur Demodulation eines mittels Einseitenband-Amplitudenmodulation übertragenen Datensignals erzeugt,

— mit einem Vorzeichenmultiplizierer (21), der das Produkt aus dem Vorzeichen des um π/4 gegenüber dem örtlichen Träger phasenverschobenen Ausgangssignals des örtlichen Oszillators (an 15) und dem Vorzeichen des noch nicht demodulierten Empfangs-Datensignals (s(t)) bildet,
— und mit einem Vorzeichenkoinzidenz-Autokorrelator (22), der das Mittel zur Frequenzregelung steuer und die Korrelation zwischen zwei Fassungen des vom Vorzeichenmultiplizierer gelieferten Signals durchführt, von denen die eine (in 7) gegenüber der anderen um ein ungeradzahliges Vielfaches einer Viertelwellenlänge des Trägers verzögert ist.

2. Regelkreis nach Anspruch 1, dadurch gekennzeichnet, daß der Vorzeichenmultiplizierer (21) das zu demodulierende Signal über ein Bandsperrfilter (19) zugeführt erhält, das einen eventuellen Rest des auf der Sendeseite für die Durchführung der Amplitudenmodulation verwendeten Trägers unterdrückt.

3. Regelkreis nach Anspruch 1, dadurch gekennzeichnet, daß der Vorzeichenmultiplizierer (21) aufweist:

— einen ersten absoluten Begrenzer (5), dem eingangsseitig das zu demodulierende Datensignal zugeführt wird und der ausgangsseitig ein Binärsignal liefert, das dem Vorzeichen des zu demodulierenden Datensignals entspricht,

— einen zweiten absoluten Begrenzer (17), der eingangsseitig den um π/4 phasenverschobenen örtlichen Träger zugeführt erhält und ausgangsseitig ein Binärsignal liefert, das dem Vorzeichen des um π/4 phasenverschobenen örtlichen Trägers entspricht,

— und einen ersten Binärmultiplizierer (6) mit zwei Eingängen, von denen der eine mit dem Ausgang des ersten absoluten Begrenzers (5) und der andere mit dem Ausgang des zweiten absoluten Begrenzers (17) verbunden ist.

4. Regelkreis nach Anspruch 1, dadurch gekennzeichnet, daß der Vorzeichenkoinzidenz-Autokorrelator (22) aufweist:

— einen Verzögerungskreis (7), dessen Eingang mit dem Ausgang des Vorzeichenmultiplizierers (21) verbunden ist und der eine Verzögerung gleich einem ungeradzahligen Vielfachen einer Viertelwellenlänge des auf der Sendeseite für die Amplitudenmodulation verwendeten Trägers einführt,

— einen zweiten Binärmultiplizierer (8) mit zwei Eingängen, von denen einer direkt und der andere über ein Verzögerungsglied (7) mit dem Ausgang des Vorzeichenmultiplizierers (21) verbunden ist,

— und einen Integrator (9), der an den Ausgang des zweiten Binärmultiplizierers (8) angeschlossen ist.

5. Regelkreis nach Anspruch 1, dadurch gekennzeichnet, daß er aufweist:

— einen ersten Vorzeichenmultiplizierer (21'), der das Produkt des Vorzeichens des mit einer Phasenvoreilung, deren theoretischer Wert π/4 ist, behafteten örtlichen Trägers mit dem Vorzeichen des zu demodulierenden Datensignals bildet,

— einen zweiten Vorzeichenmultiplizierer (31), der das Produkt des Vorzeichens des mit einer Phasenverzögerung eines theoretischen Werts π/4 versehenen örtlichen Trägers mit dem Vorzeichen des zu demodulierenden Datensignals bildet,

— einen ersten Vorzeichenkoinzidenz-Autokorrelator (22'), der die Korrelation zwischen zwei Fassungen des vom ersten Vorzeichenmultiplizierer (21') gelieferten Signals durchführt, wobei die beiden Fassungen gegeneinander um ein ungeradzahliges Vielfaches einer Viertelwellenlänge des auf der Sendeseite für die Amplitudenmodulation verwendeten Trägers gegeneinander verschoben sind,

— einen zweiten Vorzeichenkoinzidenz-Autokorrelator (32), der die Korrelation zwischen zwei Fassungen des vom zweiten Vorzeichenmultiplizierer (31) gelieferten Signals durchführt, wobei die beiden Fassungen gegeneinander um ein ungeradzahliges Vielfaches einer Viertelwellenlänge des auf der Sendeseite für die Amplitudenmodulation verwendeten Trägers gegeneinander verschoben sind,

— und einen Differentialverstärker (34), dessen erster Eingang mit dem Ausgang des ersten Vorzeichenkoinzidenz-Autokorrelators (22') und dessen zweiter Eingang mit dem Ausgang des zweiten Vorzeichenkoinzidenz-Autokorrelators (32) verbunden ist und der das Ausgangssignal des Regelkreises liefert.

**Claims**

1. A circuit for controlling the phase of a local oscillator (10) provided with a means for adjusting the frequency, and producing a local carrier for the demodulation of a data signal transmitted according to a single side band amplitude modulation, comprising

— a sign multiplier (21) producing the product between the sign of the local oscillator output signal which is phase shifted by π/4 with respect to the local carrier (at 15), and the sign of the received data signal (s(t)) prior to its demodulation, and

— a sign coincidence autocorrelator (22) controlling said frequency adjusting means and performing the correlation between two versions of the signal obtained from the sign multiplier, one phase delayed (in 7) with respect to the other by an odd multiple of a quarter carrier period.

2. A control circuit according to Claim 1, characterized in that the sign multiplier (21) receives the signal to be demodulated via a band rejection filter (19) rejecting any residue of the carrier which has been used on transmission for realizing the amplitude modulation.

3. A control circuit according to Claim 1, characterized in that the sign multiplier (21) comprises:

— a first absolute limiter (5) receiving at the input the data signal to be demodulated and delivering at the output a binary signal corresponding to the sign of the data signal to be demodulated,

— a second absolute limiter (17) receiving at its input the local carrier shifted by a phase difference of π/4 and delivering at its output a binary signal corresponding to the sign of the local carrier shifted in phase by π/4,

— and a first binary multiplier (6) having two inputs, one connected to the output of the first absolute limiter (5) and the other to the output of the second absolute limiter (17).

4. A control circuit according to Claim 1, characterized in that the sign coincidence autocorrelator (22) comprises:

— a delay circuit (7) whose input is connected to the output of the sign multiplier (21) and which introduces a delay equal to an odd multiple of a quarter carrier period used on transmission for the amplitude modulation,

— a second binary multiplier (8) having two inputs connected to the output of the sign multiplier (21), one directly and the other via the delay circuit (7),

— and an integrator (9) connected to the output of the second binary multiplier (8).

5. A control circuit according to Claim 1, characterized in that it comprises:

— a first sign multiplier (21') producing the product of the sign of the local carrier advanced by a phase difference theoretically equal to π/4 multiplied by the sign of the data signal to be demodulated,

— a second sign multiplier (31) producing the product of the sign of the local carrier delayed by a phase difference theoretically equal to π/4 multiplied by the sign of the data signal to be demodulated,

— a first sign coincidence autocorrelator (22') correlating two versions of the signal delivered by the first sign multiplier (21'), one of said versions being delayed relative to the other by an odd multiple of a quarter period of the carrier used on transmission for the amplitude modulation,

— a second sign coincidence autocorrelator (32) correlating two versions of the signal delivered by the second sign multiplier (31), one of said versions being delayed relative to the other by an odd multiple of a quarter period of the carrier used on transmission for the amplitude modulation,

— and a differential amplifier (34), a first input of which is connected to the output of the first sign coincidence autocorrelator (22') and a second input of which is connected to the output of the second sign coincidence autocorrelator the output delivering the output signal of the control circuit.

# FIG.1

0 026 372

FIG.2

# FIG. 3